# EUROPEAN PATENT SPECIFICATION

(11) **EP 0 311 690 B1**
(45) Date of publication and mention of the grant of the patent: **07.09.1994**
(21) Application number: 88902934.4
(22) Date of filing: 30.03.1988
(51) Int. Cl.: H01L 31/04

(54) **INTEGRATED SOLAR BATTERY AND METHOD OF PRODUCING THE SAME**
INTEGRIERTE SONNENZELLE UND HERSTELLUNGSVERFAHREN
PILE SOLAIRE INTEGREE ET PROCEDE DE PRODUCTION

(30) Priority: 31.03.1987 JP 80363/87
(43) Date of publication of application: 19.04.1989
(73) Proprietor: KANEGAFUCHI KAGAKU KOGYO KABUSHIKI KAISHA, Kita-ku Osaka-shi Osaka-fu 530 (JP)
(72) Inventor: TSUGE, Kazunori, Kobe-shi Hyogo 655 (JP); ENDO, Toshihito, Kobe-shi Hyogo 655 (JP); KOBAYASHI, Kenji, Kobe-shi Hyogo 655 (JP); TAWADA, Yoshihisa, Kobe-shi Hyogo 651-11 (JP)
(74) Representative: Türk, Gille, Hrabal, Leifert
(86) International application number: PCT/JP88/00319
(87) International publication number: WO 88/07768

(56) References cited:
- EP-A- 0 113 959
- WO-A-82/02284
- JP-A- 5 878 473
- JP-A- 5 929 475
- JP-A- 6 031 258
- JP-A- 6 043 869
- JP-A-55 134 989
- JP-A-58 101 468
- US-A- 4 623 751
- US-A- 4 755 475
- 19TH IEEE PHOTOVOLTAIC SPECIALISTS CONFERENCE, New Orleans, Louisana, 4th - 8th May 1987, pages 993-1000, IEEE, New York, US; R.G. ROSS: "Recent achievements in module reliability research"
- 7TH E.C. PHOTOVOLTAIC SOLAR ENERGY CONFERENCE, Servilla, 27th - 31st October 1986, pages 560-566, ES; E. ESER et al.: "Interface chemistry of tin oxide and glow discharge deposited amorphous silicon thin film couples"

## Description

### TECHNICAL FIELD

The present invention relates to an integrated solar cell device wherein many small size solar cells formed on a transparent substrate are connected in series or series-parallel therewith, and to a manufacturing method thereof.

### BACKGROUND ART

Hithereto, an integrated solar cell device wherein many small size solar cells formed on a transparent substrate are connected in series or series-parallel therewith, are made by laminating a transparent electrode comprising indium-tin oxide (hereinafter referred to as ITO), tin oxide (hereinafter referred to as SnO₂) or the like on the surface of light impinging side by laminating a metal electrode comprising aluminium, copper or the like on the opposite solar cell surface, and by constituting series connection by connecting the transparent electrode of a solar cell to the metal electrode of another solar cell.

In the above mentioned solar cell device, the transparent electrode comprising ITO, SnO₂ or the like is oxide, so that the component parts of the transparent electrode oxidize the metal electrode via a part to which the transparent electrode is contacted only by leaving the cell as it is for a long time. As a result, the contact resistance of the part increases.

Thus, there is a problem that output of the solar cell device decreases since the resistance of the series connected parts thereof increases.

Further, there is a problem that output characteristic is lowered due to oxidization of metal layer to which the trasparent electrode is connected in order to make electrical connection when the solar cell device made by the above-mentioned method is used under high temparature. Particularly, when a metal which is liable to be oxidized is employed, the output characteristic of solar cell device is remarkably lowered.

US-A-4 623 751 discloses an amorphous silicon solar cell array formed on a transparent substrate wherein the lower transparent electrode formed of SnO₂ or In₂O₃ -SnO₂ of one cell is connected to the upper metal electrode of the adjacent cell by means of an aluminium coupling electrode . A conductive anti-oxidation film, e.g. formed of nickel or platinum, is formed at the serie connection part of the upper electrode and the lower transparent electrode in order to avoid the oxidation of the Al coupling electrode

### DISCLOSURE OF THE INVENTION

The above-mentioned drawbacks being taken into 10 consideration, according to the present invention there is provided an integrated solar cell device comprising a plurality of amorphous silicon solar cells having a transparent metal oxide electrode on the light impinging side and a metal electrode on the reversed side of the light impinging side, plased on a transparent substrate , the plurality of solar cells being connected in series or series-parallel using the transparent electrode and the metal electrode thereof, wherein at least one conductive anti-oxidation film is formed at the series connection part of the transparent electrode and the metal electrode, characterized in that the anti-oxidation film is a portion of the transparent metal oxide electrode wherein the ratio of metal component is increased at least where the transparent electrode is connected with the metal electrode in order to make electric series connection, the thickness of the portion in which the metal component is increased being more than 1 nm, and in that the metal component of transparent electrode in the neighbourhood of metal electrode is at least 1.2 times as much as those of other regions of transparent electrode.

In the integrated solar cell device of the present invention having the above-mentioned construction, it is intended to prevent output of the solar cell device from decreasing by providing the anti-oxidation films between the metal electrodes and the transparent electrodes.

Namely, the anti-oxidation films are made by means of that metal component of transparent electrode at least in the neighbourhood of metal electrodes are increased as compared with other regions. It is made by increasing metal component of the subsurfaces layer of the transparent electrodes with reduction of metal oxide, or by increasing metal component of the subsurface layer of the transparent electrodes which is opposite to the transparent substrate so that metal component ratio in that region becomes larger than those of other regions.

In the present specification, the region, in which metal component ratio of the transparent electrode is varied, is included in the concept of anti-oxidation film.

In this case, the metal component ratio in subsurface layer is increased by at least 1.2 times as much as those of other regions. Further, it is necessary that the thickness of subsurface layer where the metal component ratio is increased by reduction is more than 10 Å preferably 20 Å to 30 Å (10Å=1nm). On the other hand, when the metal component ratio is 90 % by atom or more, it is preferable that the thickness of that layer is equal to or less than 150 Å.

Normal transparent substrates, which are employed in manufacturing semiconductors, such as glass and heat resistance high polymer film are enumerated as examples of the substrate employed in the present invention.

On the above-mentioned substrate, the transparent electrode, which is electrically isolated, is laminated. ITO, SnO₂ and ZnO are enumerated as concrete examples of the transparent electrode.

On the transparent electrode, which is formed on the transparent substrate with electrically isolated by patterning, amorphous silicon semiconductor layer is laminated.

In the present invention, amorphous silicon semiconductor represents semiconductor comprising only amorphous silicon semiconductor and semiconductor comprising amorphous silicon semiconductor containing crystallite substrate. a-Si:H, a-SiC:H, a-SiN:H, a-SiGe, a-SiSn, µ C-Si:H (microcrystalline) and the like are enumerated as concrete examples of amorphous silicon semiconductor.

Anti-oxidation film of the solar cell device of the present invention is formed by raising the metal component ratio of the subsurface layer of the transparent electrode which is exposed to be contacted with metal electrode by removing the over-lain amorphous silicon semiconductor layer. Raising the metal component ratio can be realized by applying gas or liquid having reduction-ability to the exposed layer of the transparent electrode. Alternatively, it may be realized by depositing metal oxide of which the metal component ratio is raised beforehand. Further, in case of making the metal component ratio especially high, it is necessary to adjust the thickness of the anti-oxidation film in order not to extremely damage the transparency of the transparent electrode. The metal component ratio can be easily measured by a conventional analysis method, for example, AES.

As a method for removing a part of the amorphous silicon semiconductor layer, an energy beam method, an etching method and a lift off method can be adopted.

Aℓ, Cu, Cr and the like are enumerated as back metal electrode. By dividing the back metal electrode into pieces, a solar cell device, wherein a plurality of solar cells are connected in series, can be obtained.

As methods for dividing the back metal electrode, an etching method, an energy beam method and a lift off method can be adopted.

### BRIEF DESCRIPTION OF THE DRAWINGS

Fig. 1 shows a sectional view of a first example of an integrated solar cell device;
Fig. 2 shows an explanatory sectional view of an amorphous silicon solar cell device of an integrated solar cell device;
Fig. 3 shows a sectional view of a second example of an integrated solar cell device;
Fig. 4 shows a sectional view of a third example of the integrated solar cell device of the present invention; and
Figs. 5 to 11 show an illustration of an embodiment of a manufacturing method of the present invention.

### BEST MODE FOR CARRING OUT THE INVENTION

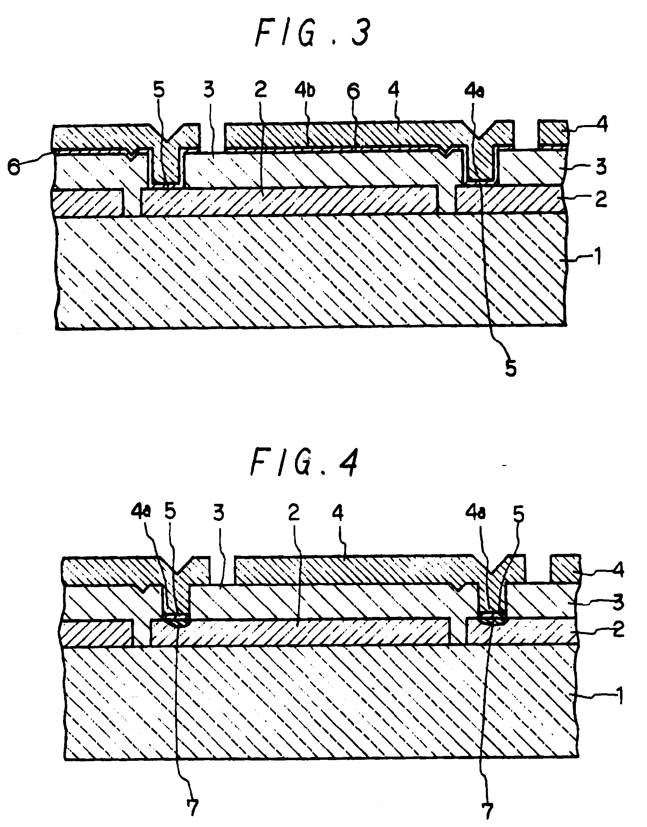

Referring now to the accompanying figures 4-11 there is explained embodiments of the present invention by way of examples.

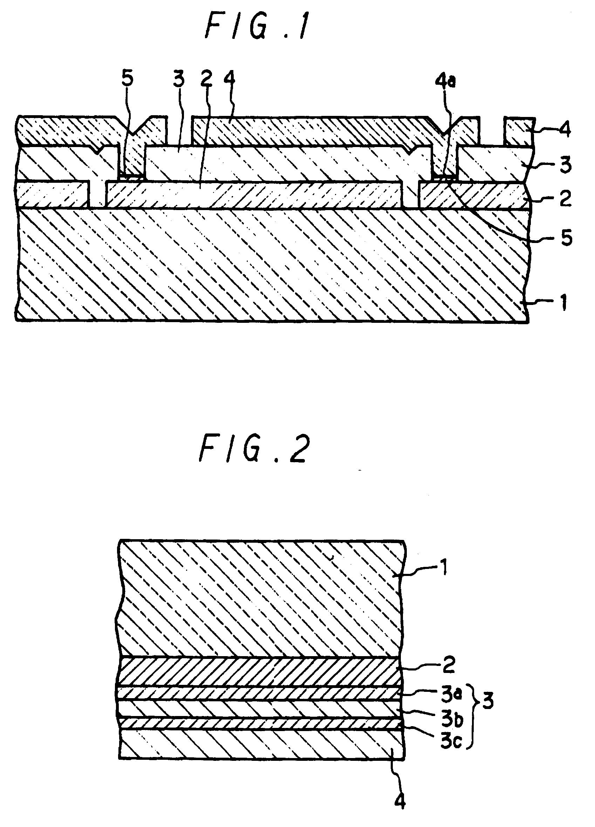

Fig. 1 shows a sectional view of an integrated solar cell device which does not form part of the present invention.

In the drawing, numeral 1 is a glass substrate which is placed on a light impinging aspect of the solar cell device.

Numeral 2 is a transparent electrode comprising a transparent conductible film such as ITO, SnO₂ or ZnO, which is patterned by etching method or laser beam method,in order for the electrode to be applyed to a small size solar cell.

Numeral 3 is a solar cell comprising an amorphous semiconductor layer which is laminated by glow discharge decomposition method, and the solar cell 3 is patterned by laser beam method and etc. like the transparent electrode 2.

A metal electrode 4 made of metal such as aluminium is formed on the amorphous semiconductor layer by electron beam deposition method as a back electrode, and then the electrode 4 is patterned by chemical etching method and the like.

The integrated solar cell device shown in Figs. 1 to 4 is a series connection type wherein solar cells placed side by side are connected to another, however, combination of series connection and parallel connection may be adopted by suitably selecting the pattern.

In this solar cell device, a metal film or a metal silicide film is formed, with metal mask, on the transparent layer 2 exposed by laser beam and the like, by means of electric beam deposition as an anti-oxidation film, before the metal electrode 4 is formed.

Metals selected among Mo, Ni, Cr, W, Pd, Pt, Mn, Fe and the like, are used for the anti-oxidation film, and the thickness of the film is in the range of 1 to 20 nm (10 to 200 Å).

Every kind of solar cell device can be applied to the present invention. As shown in Fig. 2, a pin-type of solar cell device wherein p-type amorpous silicon carbide 3a, i-type amorphous silicon 3b, n-type amorphous silicon 3b are laminated in this order from the light impinging side, is employed.

The integrated solar cell device has the above-mentioned structure, i.e. an anti-oxidation film 5 comprising metal or metal silicide is formed between a transparent electrode 2 and a metal electrode 4 of a solar cell device 3 having series connection, so that the metal electrode 4 comprising aluminium and the like is prevented from being oxidized by the transparent electrode 2 made of conductive transparent layer comprising ITO, SnO₂ or ZnO via the connecting part 4a. As a result, there can be realized a solar cell device keeping its initial output for a long time without decreasing its characteristics.

And also, since amorphous silicon solar cells are used, the cost of the solar cell device can be lowered. Particularly amorphous silicon carbide is used for p-type layer which is laminated on the light impinging side, so that the energy exchanging efficiency can be improved.

Fig. 3 is a sectional view of an integrated solar cell device which does not form part of the present invention.

A transparent electrode 2 and a solar cell 3 are laminated on the glass substrate 1 in this order, and then a part of the trnsparent electrode 2 is exposed by laser beam method and the like.

And then, the anti-oxidation film 5 is formed by depositing a film of metal such as Mo, Ni, Cr, W, Pd, Pt, Mn, Fe and the like, or a film of silicide of metal such as Mo, Ni, Cr, W, Pd, Pt, Mn, Fe and the like on the whole surface opposite to the light impinging surface.

Further, a metal electrode 4 made of metal such as aluminum is formed, and then the electrode 4 and the anti-oxidation film 5 are patterned by chemical etching method and the like.

The anti-oxidation film 5 prevents the transparent electrode 2 from oxidizing the metal electrode 4 at the connection 4a of the transparent electrode 2 and the metal electrode 4, however, the film acts as a metal diffusion-blocking film 6 at the connection 4b of the solar cell 3 and the metal electrode 4.

Namely, since the present solar cell comprises a type of amorphous solar cell, the metal component of the metal electrode 4 diffuses into the n-type amorphous silicon layer 3c by thermal and decreases the efficiency of solar cell device. However, by laminating the metal diffusion-blocking film 6, the metal component of the metal electrode 4 can be prevented from diffusing into the semiconductor layer even if the temperature of the solar cell device is raised.

Particularly, when a layer, wherein Mo, Ni, Cr and the like are selected as metal component, is laminated, the metal diffusion can be efficiently prevented.

The integrated solar cell device has the above-mentioned construction, i.e., the transparent electrode 2 and the metal electrode 4 are connected in series via the anti-oxidation film 5, so that the transparent electrode 2 is prevented from oxidizing the metal component of the metal electrode 4, and that output of the solar cell device is prevented from decreasing. And also, any masks are not used when the anti-oxidation film 5 is formed, so that the manufacturing process is simplified.

Further, the metal components of the metal electrode 4 are prevented from diffusing into the semiconductor layer by heat by means of the metal diffusion-blocking film 6, so that degradation by heat is prevented, and that it can be realized that a solar cell device has long-life.

Fig. 4 is a cross-sectional view of an embodiment of the integrated solar cell device of the present invention.

In this embodiment, a transparent electrode 2 and a solar cell layer are laminated on a glass substrate 1 in the same manners as those of the first embodiment, and then some of the transparent electrode 2 is exposed by the laser scribing and the like.

And then, a reduced layer 7 is formed by reducing the exposed parts of the transparent electrode 2 with hydrogen generated by glow discharge device, and an anti-oxidation film 5 and a metal electrode 4 are laminated like the first embodiment.

In this embodiment, a metal film of Mo, Ni, Cr, W, Pd, Pt, Mn, Fe and the like, or a metal silicide layer comprising Mo, Ni, Cr, W, Pd, Pt, Mn, Fe, and the like are used, like the above examples, as the anti-oxidation film 5 sandwitched by the reduced layer 7 and the metal electrode 4.

Alternately, as a simplified method, the reduced layer 7 may be directly contacted with the metal electrode 4 without forming the metal film or the metal silicide layer between the reduced layer 7 and the metal electrode 4.

The embodiment of the integrated solar cell device of the present invention is constructed as is mentioned above, i.e. the transparent electrode 2 is reduced at the contact part 4a of the transparent electrode 2 and the metal electrode 4 in order to increase the metal component ratio and to form the reduced layer 7 and the oxidation-proof layer 5 which acts as anti-oxidation film, i.e. increasing the effect of oxidation-proof, so that decrease of output of solar cell device can be prevented.

Next, the characteristics of the integrated solar cell device of the present invention are described in relation to examples 3, 4, 5 and 6. Examples 1, 2 and comparative examples 1 and 2 do not belong to the present invention.

### Example 1

On a blue glass plate of 1.1 mm thickness, a transparent electrode of SnO₂ of 900 nm (9000 Å) thickness was laminated, and the transparent electrode was patterned by laser beam.

And then, a silicon semiconductor layer comprising p-type amorphous carbide layer of 15 nm (150 Å) thickness, i-type amorphous silicon of 600 nm (6000 Å) and n-type crystallite silicon of 30 nm (300 Å) by glow discharge decomposition method onto the transparent electrode on the glass substrate at the temperature of 200°C under the pressure of 133 Pa (1.0 Torr).

Further, some parts of the transparent electrode were exposed by removing the over-lain semiconductor layer with laser beam, and an anti-oxidation film of Mo of 6 nm (60 Å) thickness was laminated onto the exposed parts of the transparent electrode by electron beam deposition, and an Aℓ layer of 500 nm (5000 Å) thickness were laminated onto it, and then metal electrodes was formed by patterning the Aℓ layer with chemical etching.

The initial characteristics, a characteristics after 200 hours heating at the temperature of 80°C, and a characteristics after three month leaving at room temperature of the obtained solar cell device were measured by AM-1 solar-simulator of 100 mW/cm². The results are shown in Table 1.

### Example 2

A solar cell device was made in the same manner as those of Example 1 except that a chromium silicide layer was laminated by electron beam deposition with target of chromium silicide instead of Mo metal film as anti-oxidation film.

The thickness of chromium silicide layer was in the range of 4 to 5 nm (40 to 50 Å).

The characteristics of the obtained solar cell device was measured in the same manner as those of Example 1. The results are shown in Table 1.

### Example 3

After some parts of a transparent electrode were exposed, the surfaces of the exposed parts of the transparent electrode were reduced by generating hydrogen plesmas with glow discharge device. And then, a Mo layer of 6 nm (60 Å) thickness was laminated as anti-oxidation film in the same manner as those of Example 1, and an Aℓ metal electrode was laminated in the same manner as those of Example 1.

The characteristics of the obtained solar cell device are shown in Table 1.

### Comparative Example 1

A solar cell device was made in the same manner as those of Example 1 except that an anti-oxidation film of Mo film was not laminated with electron beam deposition. The characteristics of the obtained solar cell device was measured. The results are shown in Table 1.

From Table 1, it is clearly understandable that, in the solar cell devices of Example 1, Example 2 and Example 3 of the present invention, the values of short circuit current density (Jsc) of the current-voltage characteristics of the solar cell devices, the values of FF (fill-factor) of curve factor, and the values of energy converting efficiency (η) are nearly constant even after they were heated at the temperature of 80°C for 200 hours, or even after they were left alone at room temperature for 3 months, and that the efficiency of solar cell device is prevented from decreasing without the transparent electrode oxidizing the component of metal electrode for heating or leaving them alone at room temperature.

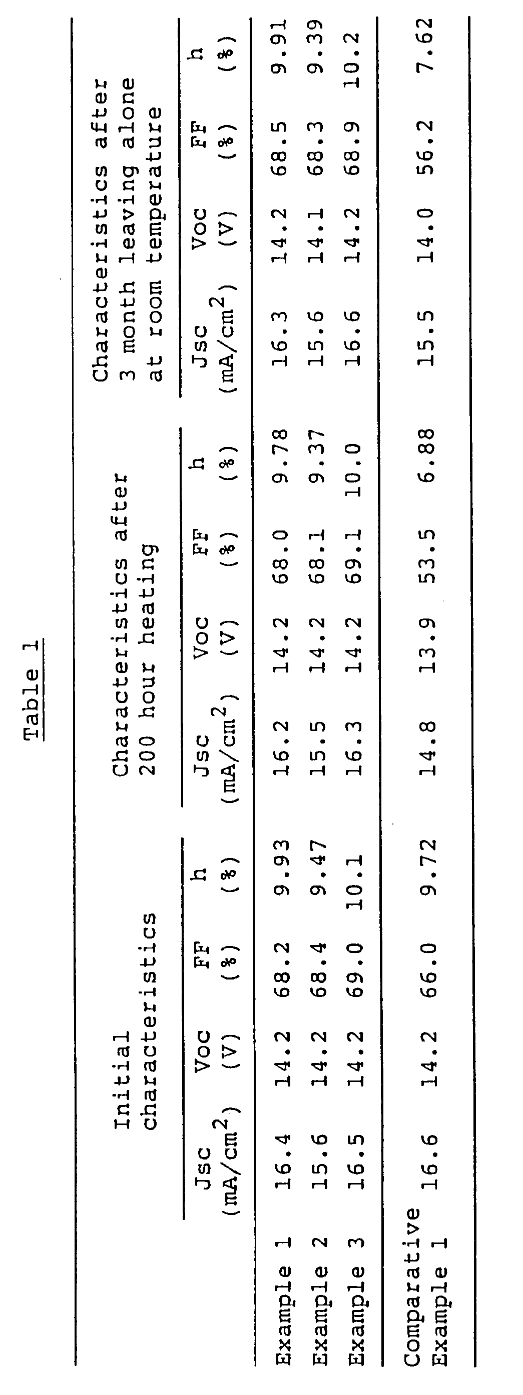

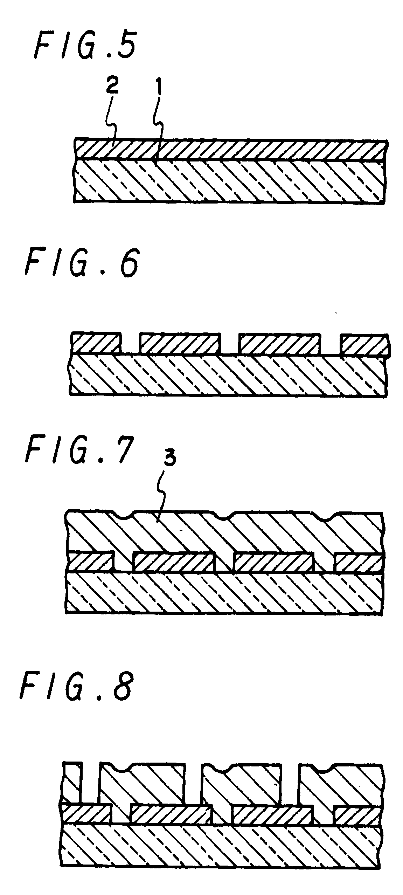

Next, there is explained an embodiment of the present invention wherein a transparent electrode is directly contacted with a metal electrode 4 without laminating a metal film or a metal silicide layer. Hereinafter there is explained an embodiment wherein the surface of transparent electrode is reduced with hydrogen plasma. Figs. 5 to 11 are schematic illustrations of the manufacturing method of the integrated solar cell device of the present invention.

At first, as shown in Fig. 5, a transparent electrode 2 of SnO₂ and the like are laminated on a transparent substrate 1 such as glass plate by CVD method and the like. Next, as shown in Fig. 6, the electrode is patterned by laser beam. And then, an amorphous silicon semiconductor layer is laminated onto it by glow discharge decomposition method and the like (refer to Fig. 7).

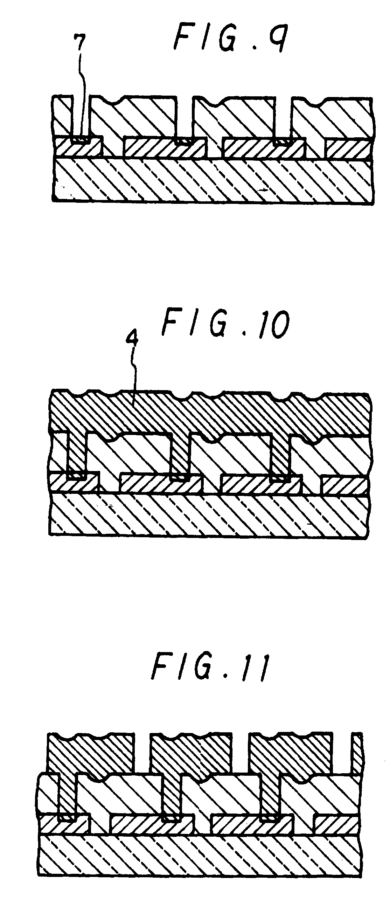

After that, as shown in Fig. 8, some parts of the amorphous semiconductor layer 3 are removed by radiating laser beam, and the under-lain transparent electrode 2 are exposed. Then, as shown in Fig. 9, a reduced layer 7 is formed by reducing the exposed transparent electrode with hydrogen plasma generated by vacumn device such as sputtering device.

As to the conditions of hydrogen plasma, hydrogen quantity of 30 to 300 sccm, chamber pressure of 39.9 to 399 Pa (0.3 to 3 Torr), substrate temperature of 180°C to laminating temperature, discharging period of 1 to 10 min. are examplified.

After the hydrogen treatment, as shown in Fig. 10, a back electrode 4 is laminated. And as shown in Fig. 11, a solar cell device of the present invention can be manufactured by the back electrode 4 being patterned.

Next, there is explained the present emodiment based on a concrete example.

### Example 4

A transparent electrode of SnO₂ of 450 nm (4500 Å) thickness was laminated on a blue glass plate of 1.1 mm thickness, and then the transparent electrode was patterned by laser beam. After that, by glow discharge decomposition method, an amorphous silicon semiconductor comprising p-type amorphous silicon layer of SiC:H of 15 nm (150 Å) thickness, i-type amorphous silicon layer of Si:H of 600 nm (6000 Å), and n-type crystallite layer of Si:H of 30 nm (300 Å) was formed at the temperature of 200°C of the substrate, under pressure of about 133 Pa (1.0 Torr). And then some parts of the transparent electrode were exposed by removing the over-lain semiconductor layer.

And then, the surface of the exposed transparent electrode was reduced by generating hydrogen plasma with sputtering device. In result, most of all the component of the exposed surface of the transparent electrode was reduced into metal Sn. And an Aℓ electrode was laminated by sputtering method till the thickness became 500 nm (5000 Å). After that, a solar cell device, wherein 16 solar cells were connected in series on a plane, was manufactured by patterning the Aℓ electrode with chemical etching. The effective area of a solar cell was about 8.75 cm², and the total effective area was about 140 cm².

The listed characteristics on Table 2 of the obtained solar cell device, having 16 solar cells being connected in series, were measured at initial and after 10 hour heating at the temperature of 150 °C, with AM-1 solar simulator of 100 mW/cm². The results are shown in Table 2.

### Example 5

A solar cell device was manufactured in the same manner as those of Example 5 except that a transparent electrode was reduced with hypo-phosphite solution instead of hydrogen plasma, and then the characteristics of the obtained solar cell device were measured. The results are shown in Table 1.

### Example 6

A substrate with transparent electrode was formed, wherein a normal SnO₂ layer of 450 nm (4500 Å) thickness was laminated on a blue glass plate and SnO₂ layer of 10 nm (100 Å) thickness, having Sn component 20 % (by atom) more than that of the normal SnO₂ layer, was laminated on the normal SnO₂ layer. After that, the transparent electrode was patterned in the same manners as those in Example 4 and a semiconductor layer was laminated onto the transparent electrode, and then some parts of the transparent electrode were exposed by removing the overlain semiconductor layer.

And an Aℓ electrode was laminated by sputtering method, and a solar cell device, wherein 16 solar cells were connected in series on a plane, was manufactured by patterning the Aℓ electrode with chemical etching. The same items as those of Example 4 were measured for the obtained solar cell device. The results are shown in Table 2.

### Comparative Example 2

A solar cell device was manufactured in the same manner as those of Example 4 except that the transparent electrode was not reduced with hydrogen plasma, and the same items as those of Example 4 were measured for the obtained solar cell device. The results are shown in Table 2.

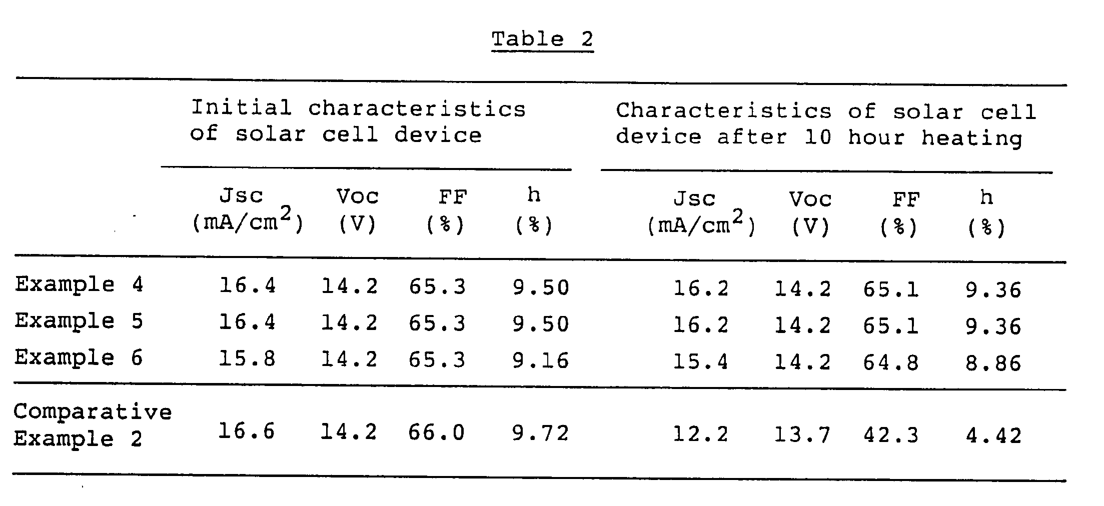

### INDUSTRIAL APPLICABILITY

In an integrated solar cell device of the present invention the contact resistance is prevented from increasing and the output of the solar cell device can be prevented from decreasing. Namely, the life of solar cell device is extented, so that the output of the solar cell device can be maintained in the designed range for a long period.

## Claims

1. An integrated solar cell device comprising a plurality of amorphous silicon solar cells (3), having a transparent metal oxide electrode (2) on the light impinging side and a metal electrode (4) on the reversed side of the light impinging side, placed on a transparent substrate (1), the plurality of solar cells being connected in series or series-parallel using the transparent electrode and the metal electrode thereof, wherein at least one conductive anti-oxidation film is formed at the series connection part of the transparent electrode and the metal electrode, characterized in that
the anti-oxidation film is a portion (7) of the transparent metal oxide electrode wherein the ratio of metal component is increased at least where the transparent electrode is connected with the metal electrode in order to make electric series connection, the thickness of the portion in which the metal component is increased being more than 1 nm, and in that
the metal component of transparent electrode in the neighbourhood of metal electrode is at least 1.2 times as much as those of other regions of transparent electrode.

2. An integrated solar cell device according to claim 1,
characterized by an additional anti-oxidation film (5) comprising metal or metal silicide and being spread out between the transparent metal oxide electrode (2) and the metal electrode (4).

3. An integrated solar cell device according to Claim 1 or 2, wherein an amorphous silicon solar cell of pin type is used as a solar cell.

4. An integrated solar cell device according to any of the Claims 1 to 3 wherein the solar cells, comprise a layer of amorphous silicon carbide on the light impinging side.

5. An integrated solar cell device according to any of the Claims 1 to 4 wherein ITO, SnO₂ or ZnO is used as a transparent electrode.

6. An integrated solar cell device according to any of the claims 2 to 4 wherein the metal of the additional anti-oxidation film is molybdenum, nickel, chromium, tungsten, palladium, platinum, manganese or iron.

7. An integrated solar cell device according to any of the claims 1 to 6 wherein the thickness of the anti-oxidation film ranges from more than 1 nm to 20 nm.

8. An integrated solar cell device according to any of the claims 2 to 7, wherein an anti-oxidation film is obtainable by reducing the transparent electrode which is connected with the metal electrode.

9. An integrated solar cell device according to any of the claims 1 to 8 wherein the transparent substrate is a glass substrate.

10. A method of manufacturing an integrated solar cell device according to claim 1 characterized in that the anti-oxidation film which is a portion (7) of the transparent metal oxide electrode is formed by reducing the exposed transparent electrode.

11. A method of claim 10, wherein the exposed transparent electrode is reduced with hydrogen plasma generated in a vacuum device.

12. A method claim 11, wherein the exposed transparent electrode is reduced in a hydrogen flow of 30 to 300 sccm, a chamber pressure of 39.9 to 399 Pa (0.3 to 3 torr), at a substrate temperature of 180 °C to depositing temperature and a discharging period of 1 to 10 min.

13. A manufacturing method of any of the claims 10 to 12 comprising a transparent electrode, an amorphous silicon semiconductor layer and a metal electrode laminated on a transparent electrode, characterized in that a plurality of amorphous silicon solar cells, having a transparent electrode on the light impinging side and a metal electrode on the reversed side of the light impinging side, are placed on a transparent substrate, and that the plurality of solar cells are connected in series or series-parallel using the transparent electrode and the metal electrode thereof, wherein at least a conductive anti-oxidation film is formed at the series connection part of the transparent electrode and the metal electrode, wherein
an anti-oxidation film is formed in such a way that the ratio of metal component of transparent electrode in the neighbourhood of metal electrode is increased at least in a part where the transparent electrode is connected with the metal electrode in order to make electric series connection, the thickness of the portion in which the metal component is increased being more than 1 nm, and
the metal component of transparent electrode in the neighbourhood of metal electrode is at least 1.2 times as much as those of other regions of transparent electrode, and
a metal silicide layer is spread out between a solar cell and a metal electrode as an additional anti-oxidation film in order to form a metal diffusion-blocking layer.

14. A method according to any of the claims 10 to 13 wherein after some parts of the amorphous semiconductor layer is removed, the surface of the exposed transparent electrode by removing the over-lain semiconductor layer is reduced and then the metal electrode is laminated.

15. A method according to claim 10 wherein the surface of the transparent electrode is reduced in a solution.

## Patentansprüche

1. Integrierte Solarzellen-Vorrichtung, die eine Vielzahl von amorphen Silicium-Solarzellen (3) umfaßt, die eine transparente Metalloxid-Elektrode (2) auf der Seite, auf die das Licht auftrifft, und eine Metallelektrode (4) auf der Rückseite der Seite, auf die das Licht auftrifft, aufweist, die auf einem transparenten Substrat (1) angeordnet sind, wobei die Vielzahl der Solarzellen in Serie oder serienparallel miteinander verbunden sind unter Verwendung der transparenten Elektrode und der Metallelektrode derselben, wobei mindestens ein elektrisch leitender Antioxidationsfilm in dem Serienkontakt-Teil der transparenten Elektrode und der Metallelektrode erzeugt wird, dadurch gekennzeichnet, daß
der Antioxidationsfilm ein Teil (7) der transparenten Metalloxid-Elektrode ist, in der der Anteil der Metallkomponente mindestens dort erhöht ist, wo die transparente Elektrode mit der Metallelektrode verbunden wird zur Herstellung einer elektrischen Serienverbindung, wobei die Dicke des Teils in dem die Metallkomponente erhöht ist, mehr als 1 nm beträgt, und daß
der Anteil der Metallkomponente der transparenten Elektrode in Nachbarschaft zu der Metallelektrode mindestens das 1,2-fache derjenigen der anderen Bereiche der transparenten Elektrode beträgt.

2. Integrierte Solarzellen-Vorrichtung nach Anspruch 1, gekennzeichnet durch einen zusätzlichen Antioxidationsfilm (5) aus Metall oder einem Metallsilicid, der zwischen der transparenten Metalloxid-Elektrode (2) und der Metallelektrode (4) angeordnet ist.

3. Integrierte Solarzellen-Vorrichtung nach Anspruch 1 oder 2, in der eine amorphe Silicium-Solarzelle vom pin-Typ als Solarzelle verwendet wird.

4. Integrierte Solarzellen-Vorrichtung nach einem der Ansprüche 1 bis 3, in der die Solarzellen eine Schicht aus amorphem Siliciumcarbid auf der Seite, auf die das Licht auftrifft, aufweisen.

5. Integrierte Solarzellen-Vorrichtung nach einem der Ansprüche 1 bis 4, in der ITO, SnO₂ oder ZnO für die transparente Elektrode verwendet wird.

6. Integrierte Solarzellen-Vorrichtung nach einem der Ansprüche 2 bis 4, in der das Metall des zusätzlichen Antioxidationsfilms Molybdän, Nickel, Chrom, Wolfram, Palladium, Platin, Mangan oder Eisen ist.

7. Integrierte Solarzellen-Vorrichtung nach einem der Ansprüche 1 bis 6, in der die Dicke des Antioxidationsfilms mehr als 1 nm bis 20 nm beträgt.

8. Integrierte Solarzellen-Vorrichtung nach einem der Ansprüche 2 bis 7, in der ein Antioxidationsfilm erhältlich ist durch Reduktion der transparenten Elektrode, die mit der Metallelektrode in Verbindung steht.

9. Integrierte Solarzellen-Vorrichtung nach einem der Ansprüche 1 bis 8, in der das transparente Substrat ein Glassubstrat ist.

10. Verfahren zur Herstellung einer integrierten Solarzellen-Vorrichtung nach Anspruch 1, dadurch gekennzeichnet, daß der Antioxidationsfilm, der ein Teil (7) der transparenten Metalloxid-Elektrode ist, durch Reduktion der freigelegten transparenten Elektrode gebildet wird.

11. Verfahren nach Anspruch 10, bei dem die freigelegte transparente Elektrode mit einem Wasserstoffplasma, das in einer Vakuumvorrichtung erzeugt wird, reduziert wird.

12. Verfahren nach Anspruch 11, in dem die freigelegte transparente Elektrode in einem Wasserstoffstrom von 30 bis 300 sccm, bei einem Kammerdruck von 39,9 bis 399 Pa (0,3 bis 3 Torr) und bei einer Substrattemperatur von 180°C bis zur Abscheidungstemperatur während einer Entladungsdauer von 1 bis 10 min reduziert wird.

13. Verfahren nach einem der Ansprüche 10 bis 12, das umfaßt eine transparente Elektrode, eine amorphe Silicium-Halbleiter-Schicht und eine Metallelektrode, die auf eine transparente Elektrode auflaminiert ist, dadurch gekennzeichnet, daß
eine Vielzahl von amorphen Silicium-Solarzellen, die eine transparente Elektrode auf der Seite, auf die das Licht auftrifft, und eine Metallelektrode auf der rückwärtigen Seite der Seite, auf die das Licht auftrifft, aufweist, auf ein transparentes Substrat aufgebracht werden und daß die Vielzahl der der Solarzellen in Serie (in Reihe) oder serienparallel miteinander verbunden werden unter Verwendung der transparenten Elektrode und der Metallelektrode derselben, wobei mindestens ein elektrisch leitender Antioxidationsfilm an dem Reihenverbindungsteil der transparenten Elektrode und der Metallelektrode gebildet wird, wobei
ein Antioxidationsfilm in der Weise gebildet wird, daß der Anteil der Metallkomponente der transparenten Elektrode in der Nachbarschaft zur Metallelektrode erhöht wird mindestens in dem Teil, in dem die transparente Elektrode mit der Metallelektrode verbunden wird zur Herstellung einer elektrischen Serienverbindung, wobei die Dicke des Teils, in dem der Anteil der Metallkomponente erhöht ist, mehr als 1 nm beträgt, und
der Anteil der Metallkomponente der transparenten Elektrode in Nachbarschaft zu der Metallelektrode mindestens das 1,2-fache desjenigen der anderen Bereiche der transparenten Elektrode beträgt, und
eine Metallsilicid-Schicht zwischen einer Solarzelle und einer Metallelektrode als zusätzlicher Antioxidationsfilm vorgesehen ist zur Bildung einer Metalldiffusions-Blockierungsschicht.

14. Verfahren nach einem der Ansprüche 10 bis 13, bei dem nach der Entfernung einiger Teile der amorphen Halbleiter-Schicht die Oberfläche der durch Entfernung der darüberliegenden Halbleiter-Schicht freigelegten transparenten Elektrode reduziert wird und dann die Metallelektrode auflaminiert wird.

15. Verfahren nach Anspruch 10, in dem die Oberfläche der transparenten Elektrode in Lösung reduziert wird.

## Revendications

1. Dispositif à piles solaires comprenant une pluralité de piles solaires (3) au silicium amorphe, possédant une électrode transparente (2) formée d'un oxyde métallique et placée sur le côté d'incidence de la lumière, et une électrode métallique (4) située sur le côté opposé au côté d'incidence de la lumière et placée sur un substrat transparent (1), la pluralité de piles solaires étant raccordées en série ou selon un montage série-parallèle au moyen de leur électrode transparente et de leur électrode métallique, et dans lequel au moins une pellicule conductrice de protection contre l'oxydation est formée dans la partie de raccordement série de l'électrode transparente et de l'électrode métallique, caractérisé en ce que
la pellicule de protection contre l'oxydation est une partie (7) de l'électrode transparente formée de l'oxyde métallique, le pourcentage du constituant métallique étant accru au moins à l'endroit où l'électrode transparente est connectée à l'électrode métallique pour établir la connexion électrique en série, et l'épaisseur de la partie, dans laquelle le pourcentage du constituant métallique est accru, étant supérieure à 1 nm, et en ce que
le pourcentage du constituant métallique de l'électrode transparente au voisinage de l'électrode métallique est égal au moins à 1,2 fois celui présent dans d'autres régions de l'électrode transparente.

2. Dispositif à piles solaires intégrées selon la revendication 1, caractérisé par une pellicule additionnelle (5) de protection contre l'oxydation, comprenant un métal ou un siliciure métallique et s'étendant entre l'électrode transparente (2) formée de l'oxyde métallique et l'électrode métallique (4).

3. Dispositif à piles solaires intégrées selon la revendication 1 ou 2, dans lequel une pile solaire en silicium amorphe du type pin est utilisée en tant que pile solaire.

4. Dispositif à piles solaires intégrées selon l'une quelconque des revendications 1 à 3, dans lequel les piles solaires comprennent une couche de carbure de silicium amorphe sur le côté d'incidence de la lumière.

5. Dispositif à piles solaires intégrées selon l'une quelconque des revendications 1 à 4, dans laquelle ITO, SnO₂ ou ZnO est utilisé pour constituer l'électrode transparente.

6. Dispositif à piles solaires intégrées selon l'une quelconque des revendications 2 à 4, dans lequel le métal de la pellicule additionnelle de protection contre l'oxydation est du molybdène, du nickel, du chrome, du tungstène, du palladium, du platine, du manganèse ou du fer.

7. Dispositif à piles solaires intégrées selon l'une quelconque des revendications 1 à 6, dans lequel l'épaisseur de la pellicule de protection contre l'oxydation est comprise entre plus de 1 nm et 20 nm.

8. Dispositif à piles solaires intégrées selon l'une quelconque des revendications 2 à 7, dans lequel une pellicule de protection contre l'oxydation peut être obtenue par réduction de l'électrode transparente, qui est raccordée à l'électrode métallique.

9. Dispositif à piles solaires intégrées selon l'une quelconque des revendications 1 à 8, dans lequel le substrat transparent est un substrat en verre.

10. Procédé de fabrication d'un dispositif à piles solaires intégrées selon la revendication 1, caractérisé en ce que la pellicule de protection contre l'oxydation, qui est une partie (7) de l'électrode transparente formée d'un oxyde métallique, est formée par réduction de l'électrode transparente exposée.

11. Procédé selon la revendication 10, selon lequel l'électrode transparente exposée est réduite au moyen d'un plasma d'hydrogène produit dans un dispositif à vide.

12. Procédé selon la revendication 11 , selon lequel l'électrode transparente exposée est réduite dans un courant d'hydrogène de 30 à 300 cm³ dans les conditions standards avec une pression de chambre comprise entre 39,9 et 399 Pa (0,3 et 3 torrs), à une température de substrat comprise entre 180°C et la température de dépôt, et une durée de décharge de 1 à 10 mn.

13. Procédé selon l'une quelconque des revendications 10 à 12, comprenant une électrode transparente, une couche semiconductrice en silicium amorphe et une électrode métallique superposées sur une électrode transparente, caractérisé en ce qu'une pluralité de piles solaires en silicium amorphe, possédant une électrode transparente sur le côté d'incidence de la lumière et une électrode métallique sur le côté opposé au côté d'incidence de la lumière, sont placées sur un substrat transparent, et que la pluralité de piles solaires sont branchées en série ou selon un montage série-parallèle au moyen de leur électrode transparente et de leur électrode métallique, au moins une pellicule conductrice de protection contre l'oxydation étant formée au niveau de la partie de connexion en série de l'électrode transparente et de l'électrode métallique, et
selon lequel on forme une pellicule de protection contre l'oxydation de manière que le pourcentage du constituant métallique de l'électrode transparente au voisinage de l'électrode métallique soit accru au moins dans une partie où l'électrode transparente est connectée à l'électrode métallique pour réaliser la connexion électrique en série, l'épaisseur de la partie, dans laquelle le pourcentage du constituant métallique est accru, étant supérieure à 1 nm, et
le pourcentage du constituant métallique de l'électrode transparente au voisinage de l'électrode métallique est égal à au moins 1,2 fois celui présent dans d'autres régions de l'électrode transparente, et
une couche de siliciure métallique s'étend entre une pile solaire et une électrode métallique en tant que pellicule supplémentaire de protection contre l'oxydation, de manière à former une couche empêchant la diffusion du métal.

14. Procédé selon l'une quelconque des revendications 10 à 13, selon lequel après élimination de certaines parties de la couche semiconductrice amorphe, la surface de l'électrode transparente exposée est réduite par élimination de la couche semiconductrice superposée, puis l'électrode métallique est déposée.

15. Procédé selon la revendication 10, selon lequel la surface de l'électrode transparente est réduite dans une solution.
